(19) Europäisches Patentamt
European Patent Office
Office européen des brevets

(11) **EP 3 971 675 B1**

(12) **EUROPEAN PATENT SPECIFICATION**

(45) Date of publication and mention of the grant of the patent:
**06.03.2024 Bulletin 2024/10**

(21) Application number: **20852270.6**

(22) Date of filing: **08.04.2020**

(51) International Patent Classification (IPC):
**G05D 23/19** (2006.01)

(52) Cooperative Patent Classification (CPC):
**G05D 23/1931**

(86) International application number:
**PCT/CN2020/083615**

(87) International publication number:
**WO 2021/027298 (18.02.2021 Gazette 2021/07)**

(54) **CONTROL METHOD AND CONTROL DEVICE FOR HEAT DISSIPATION ELEMENT**

STEUERVERFAHREN UND STEUERVORRICHTUNG FÜR EIN WÄRMEABLEITUNGSELEMENT

PROCÉDÉ DE COMMANDE ET DISPOSITIF DE COMMANDE POUR ÉLÉMENT DE DISSIPATION DE CHALEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.08.2019 CN 201910745537**

(43) Date of publication of application:
**23.03.2022 Bulletin 2022/12**

(73) Proprietor: **Huawei Digital Power Technologies Co., Ltd.**
**Shenzhen, Guangdong 518043 (CN)**

(72) Inventors:
• **LI, Junjie**
  **Shenzhen, Guangdong 518129 (CN)**
• **YU, Xinyu**
  **Shenzhen, Guangdong 518129 (CN)**
• **XIN, Kai**
  **Shenzhen, Guangdong 518129 (CN)**
• **FU, Jiaguang**
  **Shenzhen, Guangdong 518129 (CN)**

(74) Representative: **Maiwald GmbH**
**Elisenhof**
**Elisenstraße 3**
**80335 München (DE)**

(56) References cited:
EP-A1- 3 267 774     CN-A- 101 739 037
CN-A- 106 960 719    CN-A- 107 489 639
CN-A- 109 933 109    CN-A- 110 543 196
DE-A1-102017 205 033   US-A1- 2007 213 882
US-B2- 8 594 856

## Description

### TECHNICAL FIELD

This application relates to the field of electronic technologies, and specifically, to a heat dissipating element control method, and a control apparatus.

### BACKGROUND

With an industrial development requirement, power levels of various electronic devices, such as an inverter, are gradually increased. The inverter is a power converter that converts a direct current into an alternating current by using a power electronics technology. In various high-power electronic devices, power consumption generated by a core component of the high-power electronic device is usually a main part of power consumption of the entire electronic device. Due to high power consumption, the core component may generate a large amount of heat when running in the high-power electronic device. Therefore, a heat dissipating element, such as a fan heat dissipating element or a water-cooled heat dissipating element, needs to be configured in the electronic device, and effective cooling and heat dissipating need to be performed on the heat emitting component by using the heat dissipating element, to prevent the component from being burnt due to an excessively high running temperature of the component.

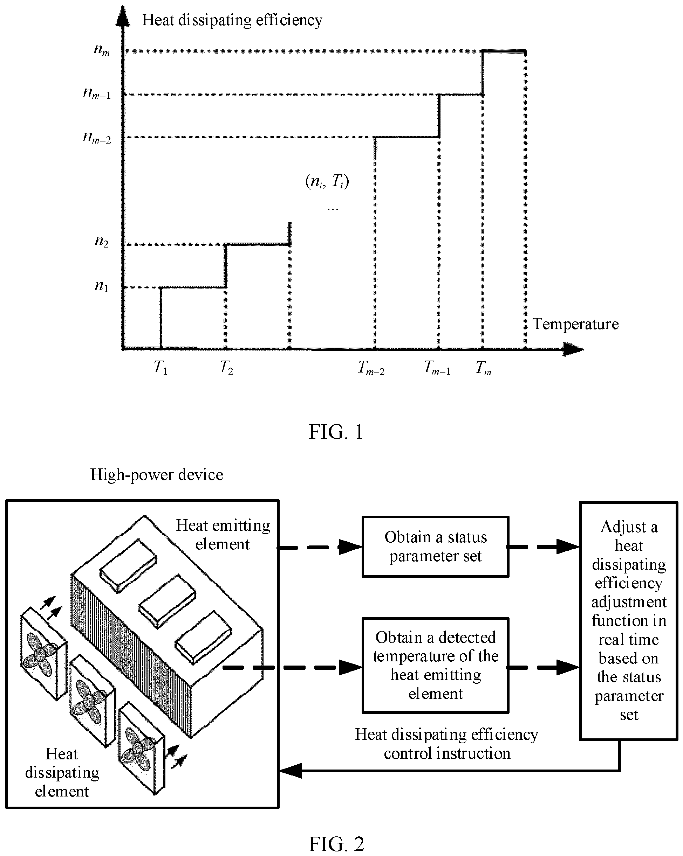

A component on which cooling and heat dissipating need to be performed by using a heat dissipating element may be referred to as a heat emitting element. Higher heat dissipating efficiency of the heat dissipating element indicates a better heat dissipating effect of the heat dissipating element for the heat emitting element, and also indicates a shorter service life of the heat dissipating element. Therefore, to ensure safe running of the heat emitting element and also increase a service life of the heat dissipating element, heat dissipating efficiency of the heat dissipating element needs to be correspondingly adjusted based on a detected temperature of the heat emitting element. Currently, an adjustment method widely used in the industry is a table lookup method. That is, based on a detected temperature of a heat emitting element, heat dissipating efficiency corresponding to the detected temperature is queried in a preset mapping relationship table, to output a corresponding control instruction to control running of a heat dissipating element. In this method, a change in heat dissipating efficiency of the heat dissipating element is shown in FIG. 1. In this method, if higher control accuracy needs to be achieved, a large quantity of points need to be set in the preset mapping relationship table. As a result, the mapping relationship table occupies excessively large storage space, and a table lookup execution period is longer. If a quantity of points is excessively small, a large temperature range corresponds to only one heat dissipating efficiency value. Therefore, heat dissipating efficiency switching is not smooth enough. In addition, for compatibility with a high temperature state, heat dissipating efficiency corresponding to each temperature range is usually set to be large, affecting a service life of the heat dissipating element.

In addition, the detected temperature of the heat emitting element is usually detected by an additional temperature detection element, and the heat emitting element is connected to the temperature detection element by using a connection apparatus. However, due to thermal resistance, the temperature detection element has specific hysteresis in detecting an actual temperature of the heat emitting element. When a running status of an electronic device suddenly changes, a temperature of a heat emitting element in the electronic device may accordingly change rapidly. However, a temperature detection element cannot reflect an actual temperature of the heat emitting element in real time, that is, a detected temperature of the heat emitting element is different from the actual temperature. In addition, a fixed mapping relationship table is possibly inapplicable to a working condition after the running status suddenly changes. Therefore, heat dissipating efficiency of a heat dissipating element cannot be adjusted in time based on the fixed mapping relationship table and the detected temperature of the heat emitting element, affecting safe running of the heat emitting element.

German patent application DE 10 2017 205 033 A1 discloses a method for controlling a heating and/or cooling apparatus. European patent application EP 3 267 774 A1 discloses a method of evaluating a heat dissipation system condition for a power module, including a calculation of a cooling fluid flow rate.
United States patent US 8,594,856 B2 discloses a method of controlling cooling of a processor.

### SUMMARY

Embodiments of this application provide a heat dissipating element control method, and a control apparatus, so that heat dissipating efficiency of a heat dissipating element can be adjusted in real time when a running status of a high-power device changes, to determine corresponding heat dissipating efficiency in advance when a detected temperature of a heat emitting element does not change. This resolves a problem that the heat dissipating efficiency is not adjusted in time because the detected temperature cannot reflect an actual temperature in real time.

In view of this, a first aspect of the embodiments of this application provides a heat dissipating element control method. The control method includes: obtaining a status parameter set and a detected temperature of a first device, where the status parameter set includes at least one running status parameter, the at least one running status parameter is a parameter that affects a temperature of the first device when the first device runs, the first device is a high-power electronic device and the detected temperature is a temperature detected by a temperature detection element inside the first device for a heat emitting element. The method further comprises setting the heat dissipating efficiency of the heat dissipating element based on a value of a first temperature parameter, a value of a second temperature parameter, and the detected temperature, wherein the values of the first temperature parameter and the second temperature parameter are in a target adjustment function based on the status parameter set, the target adjustment function is a function with the detected temperature being an independent variable and heat dissipating efficiency of a heat dissipating element being a dependent variable; and controlling running of the heat dissipating element based on the heat dissipating efficiency.

It may be learned from the first aspect that, the values of the first temperature parameter and the second temperature parameter in the target adjustment function are determined based on the status parameter set of the first device, that is, when a running status parameter of the first device changes, the values of the first temperature parameter and the second temperature parameter in the target adjustment function also change accordingly, so that the target adjustment function can output correct heat dissipating efficiency of the heat dissipating element when the detected temperature does not change, to control the heat dissipating element to run based on heat dissipating efficiency required in an actual condition. Therefore, the heat dissipating efficiency of the heat dissipating element is adjusted in advance without a need to wait for hysteresis duration required for changing of the detected temperature, thereby resolving a problem that the heat dissipating efficiency of the heat dissipating element cannot be adjusted in time because after the running status parameter of the first device changes, an actual temperature of the heat emitting element in the first device rapidly changes, but the detected temperature cannot change in real time with the actual temperature of the heat emitting element.

Optionally, with reference to the first aspect, in a first possible implementation, the determining a value of a first temperature parameter in a target adjustment function based on the status parameter set includes: determining, from the status parameter set, a running status parameter associated with the first temperature parameter, to obtain a first associated parameter set; and determining the value of the first temperature parameter based on a preset first mapping relationship function and the first associated parameter set, where the first mapping relationship function is used to represent a mapping relationship between the running status parameter in the first associated parameter set and the first temperature parameter. Fast operation may be performed by using the pre-built first mapping relationship function and the first associated parameter set, to obtain the value of the first temperature parameter.

Optionally, with reference to the first possible implementation of the first aspect, in a second possible implementation, in the first mapping relationship function, the value of the first temperature parameter is a difference between a preset maximum value of the first temperature parameter and a first adjustment value, and the first adjustment value is obtained by performing weighted summation on values of all running status parameters in the first associated parameter set based on weight values respectively corresponding to all the running status parameters in the first associated parameter set.

Optionally, with reference to the second possible implementation of the first aspect, in a third possible implementation, the control method further includes: determining, based on a user instruction, the weight values respectively corresponding to all the running status parameters in the first associated parameter set, to meet different value requirements in a plurality of different actual cases.

Optionally, with reference to any one of the first aspect or the first to the third possible implementations of the first aspect, in a fourth possible implementation, the determining a value of a second temperature parameter in a target adjustment function based on the status parameter set includes: determining, from the status parameter set, a running status parameter associated with the second temperature parameter, to obtain a second associated parameter set; and determining the value of the second temperature parameter based on a preset second mapping relationship function and the second associated parameter set, where the second mapping relationship function is used to represent a mapping relationship between the running status parameter in the second associated parameter set and the second temperature parameter. Fast operation may be performed by using the pre-built second mapping relationship function and the second associated parameter set, to obtain the value of the second temperature parameter.

Optionally, with reference to the fourth possible implementation of the first aspect, in a fifth possible implementation, in the second mapping relationship function, the value of the second temperature parameter is a difference between a preset maximum value of the second temperature parameter and a second adjustment value, the second adjustment value is associated with a preset adjustment threshold and a ratio of a value of a target running status parameter to a rated value corresponding to the target running status parameter, and the target status parameter is a running status parameter in the second associated parameter set.

The first device is an inverter, and the status parameter set specifically includes a direct current bus voltage, an output current, a switching frequency, a modulation scheme parameter, and a power factor.

A second aspect of the embodiments of this application provides a control apparatus. The control apparatus includes:

an obtaining unit, configured to obtain a status parameter set and a detected temperature of a first device, where the status parameter set includes at least one running status parameter, the at least one running status parameter is a parameter that affects a temperature of the first device when the first device runs, and the first device is a high-power electronic device;

a first determining unit, configured to obtain a value of a first temperature parameter in a target adjustment function based on the status parameter set, where the target adjustment function is a function with the detected temperature being an independent variable and heat dissipating efficiency of a heat dissipating element being a dependent variable;

a second determining unit, configured to obtain a value of a second temperature parameter in the target adjustment function based on the status parameter set;

a third determining unit, configured to set the heat dissipating efficiency of the heat dissipating element based on the value of the first temperature parameter, the value of the second temperature parameter, and the detected temperature; and

a control unit, configured to control running of the heat dissipating element based on the heat dissipating efficiency of the heat dissipating element.

The first device is an inverter, and the status parameter set comprises a direct current bus voltage, an output current, a switching frequency, a modulation scheme parameter, and a power factor.

Optionally, with reference to the second aspect, in a first possible implementation, the first determining unit is specifically configured to determine, from the status parameter set, a running status parameter associated with the first temperature parameter, to obtain a first associated parameter set; and the first determining unit is further specifically configured to determine the value of the first temperature parameter based on a preset first mapping relationship function and the first associated parameter set, where the first mapping relationship function is used to represent a mapping relationship between the running status parameter in the first associated parameter set and the first temperature parameter.

Optionally, with reference to the first possible implementation of the second aspect, in a second possible implementation, in the first mapping relationship function, the value of the first temperature parameter is a difference between a preset maximum value of the first temperature parameter and a first adjustment value, and the first adjustment value is obtained by performing weighted summation on values of all running status parameters in the first associated parameter set based on weight values respectively corresponding to all the running status parameters in the first associated parameter set.

Optionally, with reference to the second possible implementation of the second aspect, in a third possible implementation, the control apparatus further includes: a fourth determining unit, configured to determine, based on a user instruction, the weight values respectively corresponding to all the running status parameters in the first associated parameter set.

Optionally, with reference to any one of the second aspect or the first to the third possible implementations of the second aspect, in a fourth possible implementation, the second determining unit is specifically configured to determine, from the status parameter set, a running status parameter associated with the second temperature parameter, to obtain a second associated parameter set; and the second determining unit is further specifically configured to determine the value of the second temperature parameter based on a preset second mapping relationship function and the second associated parameter set, where the second mapping relationship function is used to represent a mapping relationship between the running status parameter in the second associated parameter set and the second temperature parameter.

Optionally, with reference to the fourth possible implementation of the second aspect, in a fifth possible implementation, in the second mapping relationship function, the value of the second temperature parameter is a difference between a preset maximum value of the second temperature parameter and a second adjustment value, the second adjustment value is associated with a preset adjustment threshold and a ratio of a value of a target running status parameter to a rated value corresponding to the target running status parameter, and the target status parameter is a running status parameter in the second associated parameter set.

A third aspect of the embodiments of this application provides a control apparatus. The control apparatus includes a processor, the processor is coupled to a memory, the memory is configured to store an instruction, the processor is configured to execute the instruction stored in the memory, and the execution of the instruction stored in the memory enables the processor to execute the heat dissipating element control method in any one of the first aspect or the possible implementations of the first aspect. Optionally, the control apparatus further includes the memory.

A fourth aspect of this application provides a computer-readable storage medium. The computer-readable storage medium stores an instruction. When the instruction runs on a computer, the computer is enabled to execute the heat dissipating element control method in any one of the first aspect or the possible implementations of the first aspect.

In the embodiments of this application, first, the status parameter set and the detected temperature of the first device are obtained, where the status parameter set includes the at least one running status parameter, the at least one running status parameter is a parameter that affects the temperature of the first device when the first device runs, and the detected temperature may be a detected temperature of a heat emitting element in the first device; then, the value of the first temperature parameter and the value of the second temperature parameter in the target adjustment function are determined based on the status parameter set, where the target adjustment function is a function with the detected temperature of the first device being an independent variable and the heat dissipating efficiency of the heat dissipating element being a dependent variable; and after the values of the first temperature parameter and the second temperature parameter are determined, the heat dissipating efficiency of the heat dissipating element is determined based on the value of the first temperature parameter, the value of the second temperature parameter, and the detected temperature, and running of the heat dissipating element is controlled based on the determined heat dissipating efficiency of the heat dissipating element. In this solution, the values of the first temperature parameter and the second temperature parameter in the target adjustment function are determined based on the status parameter set of the first device, that is, when a running status parameter of the first device changes, the values of the first temperature parameter and the second temperature parameter in the target adjustment function also change accordingly, so that the target adjustment function can output correct heat dissipating efficiency of the heat dissipating element when the detected temperature does not change, to control the heat dissipating element to run based on heat dissipating efficiency required in an actual condition. Therefore, the heat dissipating efficiency of the heat dissipating element is adjusted in advance without a need to wait for hysteresis duration required for changing of the detected temperature, thereby resolving a problem that the heat dissipating efficiency of the heat dissipating element cannot be adjusted in time because after the running status parameter of the first device changes, an actual temperature of the heat emitting element in the first device rapidly changes, but the detected temperature cannot change in real time with the actual temperature of the heat emitting element. This can effectively protect the heat emitting element in the first device from running at a high temperature and being burnt because the temperature of the heat emitting element rapidly rises, but the heat dissipating efficiency of the heat dissipating element is not high enough; and can also reduce the heat dissipating efficiency of the heat dissipating element in time when the actual temperature of the heat emitting element rapidly drops, thereby helping increase a life of the heat dissipating element. In this solution, the values of the first temperature parameter and the second temperature parameter in the target adjustment function may be updated in real time when the first device is in different working conditions, that is, has different running status parameters. This resolves a problem that an adjustment rate of the heat dissipating efficiency of the heat dissipating element cannot keep pace with a change rate of the actual temperature of the heat emitting element after the running status parameter changes. In addition, the heat dissipating efficiency of the heat dissipating element is calculated by using the target adjustment function, so that continuous adjustment can be performed in real time based on the detected temperature. This implements smooth heat dissipating efficiency switching.

## BRIEF DESCRIPTION OF DRAWINGS

FIG. 1 is a schematic diagram of a change status of heat dissipating efficiency in a table lookup method;
FIG. 2 is a schematic diagram of a system architecture of a technical solution of this application;
FIG. 3 is a schematic diagram of an embodiment of a heat dissipating element control method according to an embodiment of this application;
FIG. 4 is a schematic diagram of another embodiment of a heat dissipating element control method according to an embodiment of this application;
FIG. 5 is a schematic diagram of function curves of target adjustment functions corresponding to different status parameter sets according to an embodiment of this application;
FIG. 6A and FIG. 6B are a schematic diagram of implementation effect comparison between a technical solution of this application and a table lookup solution;
FIG. 7 is a schematic diagram of an embodiment of a control apparatus according to an embodiment of this application; and
FIG. 8 is a schematic diagram of another embodiment of a control apparatus according to an embodiment of this application.

## DESCRIPTION OF EMBODIMENTS

The following describes the embodiments of this application with reference to the accompanying drawings. Clearly, the described embodiments are merely some rather than all of the embodiments of this application. It may be learned by a person of ordinary skill in the art that, with evolution of a graph computing framework and emergence of a new application scenario, the technical solutions provided in the embodiments of this application are also applicable to a similar technical problem.

In the specification, claims, and accompanying drawings of this application, the terms such as "first" and "second" are intended to distinguish between similar objects but do not necessarily indicate a specific order or sequence. It should be understood that the data termed in such a way is interchangeable in a proper circumstance so that the embodiments described herein can be implemented in an order other than the order illustrated or described herein. Moreover, the terms "include", "have", and any other variants are intended to cover the non-exclusive inclusion. For example, a process, method, system, product, or device that includes a list of steps or modules is not necessarily limited to those steps or modules expressly listed, but may include other steps or modules not expressly listed or inherent to such a process, method, system, product, or device. The names or numbers of the steps in this application do not mean that the steps in the method procedure must be executed according to the time/logical order indicated by the names or numbers, and the execution order of the procedure steps that have been named or numbered may be changed based on the to-be-achieved technical objective, provided that the same or similar technical effects can be achieved. Division into the modules in this application is logical division. During implementation in an actual application, another division manner may be used. For example, a plurality of modules may be combined or integrated into another system, or some features may be ignored or not executed. In addition, the displayed or discussed mutual couplings or direct couplings or communication connections may be implemented by using some interfaces. The indirect couplings or communication connections between the modules may be implemented in electronic or other similar forms. This is not limited in this application. In addition, modules described as separate components may be or may not be physically separated, or may be or may not be physical modules, or may not be distributed in a plurality of circuit modules. Some or all of the modules may be selected based on an actual requirement, to achieve the objectives of the solutions of this application.

The embodiments of this application may be applied to various high-power electronic devices, for example, conversion devices, such as an inverter and a transformer, applied to a power grid system, and radio devices, such as a high-power base station and radar. These high-power electronic devices are characterized by being prone to emit heat. Inside these devices, some elements (including a chip or a circuit) emit large amounts of heat. Therefore, special heat dissipating elements (such as heat dissipating fans or water-cooled heat sinks) need to be configured in these devices to dissipate heat for these elements that emit large amounts of heat. A system architecture of a technical solution of this application is shown in FIG. 2. A status parameter set of a high-power device is obtained and a heat dissipating efficiency adjustment function of a heat dissipating element is adjusted in real time based on the status parameter set; and heat dissipating efficiency of the heat dissipating element is output based on a detected temperature of a heat emitting element, to deliver a corresponding heat dissipating efficiency control instruction to the heat dissipating element to control the heat dissipating element to dissipate heat for the heat emitting element. The status parameter set includes at least one running status parameter that affects a temperature of the device when the high-power device runs. An inverter is used as an example. The inverter mainly includes a direct current input module, an alternating current output module, a heat dissipating fan, a heat sink, a power module, and a temperature detection element. The power module is a core component of the inverter, and is an electronic switch component. A switch chip in the power module controls electric energy conversion through on/off switching. The power module is a component with a largest power consumption ratio in the inverter, and is a main generation unit of an amount of emitted heat of the inverter. The heat dissipating fan and the heat sink may be collectively referred to as a heat dissipating element. The power module may be installed on the heat sink. The heat dissipating fan may actively drive the heat sink to perform air cooling and heat dissipating. The heat sink may passively dissipate heat for the power module based on an air flow agitated by the heat dissipating fan. The temperature detection element is configured to detect a temperature of the switch chip in the power module. Heat dissipating efficiency of the heat dissipating element may be adjusted based on a temperature detected by the temperature detection element, to ensure that the power module runs within an allowed temperature range and increase a service life of the heat dissipating element.

To resolve a problem, in an existing adjustment manner of heat dissipating efficiency of a heat dissipating element, that heat dissipating efficiency switching is not smooth and heat dissipating efficiency cannot be adjusted in time when a running status of a device suddenly changes, the embodiments of this application provide a heat dissipating element control method. The embodiments of this application further provide a corresponding control apparatus. The following separately provides detailed descriptions.

In the embodiments of this application, the heat dissipating element control method provided in the embodiments of this application may be executed by the control apparatus provided in the embodiments of this application. The control apparatus may be a chip, or may be a circuit. The control apparatus is configured to control heat dissipating efficiency used by a heat dissipating element in a high-power electronic device during running. The control apparatus may be integrated into the high-power electronic device; or may be independent of the high-power electronic device, and coupled to an internal element of the high-power electronic device by using a connection apparatus. This is not specifically limited in this application.

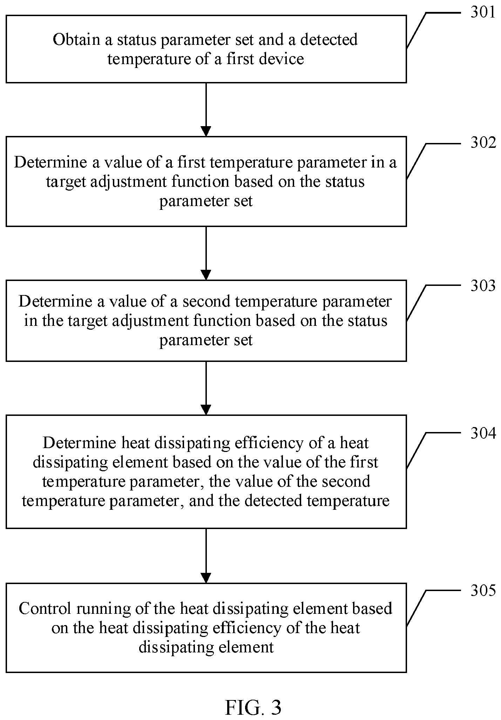

FIG. 3 is a schematic diagram of an embodiment of a heat dissipating element control method according to an embodiment of this application.

As shown in FIG. 3, this embodiment may include the following steps.

301. Obtain a status parameter set and a detected temperature of a first device.

In this embodiment, the status parameter set includes at least one running status parameter, and the at least one running status parameter is a parameter that affects a temperature of the first device when the first device runs. Specifically, the at least one running status parameter directly affects power consumption of the first device, and therefore indirectly affects the temperature of the first device. The detected temperature is specifically a detected temperature of a heat emitting element in the first device, and the detected temperature may be detected by a temperature detection element in the first device. However, due to thermal resistance, the temperature detection element cannot reflect an actual temperature change in the heat emitting element in real time, that is, the detected temperature cannot change with an actual temperature of the heat emitting element. The status parameter set of the first device may reflect an actual temperature change trend of the heat emitting element. A value of a parameter in a target adjustment function may be determined based on the status parameter set. The target adjustment function is a function with the detected temperature being an independent variable and heat dissipating efficiency of a heat dissipating element being a dependent variable. After the value of the parameter in the target adjustment function is determined based on the status parameter set, the target adjustment function may be enabled to output heat dissipating efficiency corresponding to the actual temperature of the heat emitting element even when the detected temperature has not changed, to meet a heat dissipating requirement of the heat emitting element at the actual temperature.

It should be understood that in this embodiment, the heat dissipating element may correspond to different types of heat dissipating apparatuses, and the heat dissipating efficiency corresponds to different parameters. For example, when the heat dissipating element is a combination of a fan and a heat sink, the heat dissipating efficiency may correspond to a rotation speed, a duty cycle, or a working voltage of the fan. When the heat dissipating apparatus is a water-cooled heat sink, the heat dissipating efficiency may correspond to a cooling water flow rate or running power of a water flow driven motor. This is not specifically limited herein in this application.

302. Determine a value of a first temperature parameter in the target adjustment function based on the status parameter set.

In this embodiment, the first temperature parameter is a parameter in the target adjustment function. When the status parameter set of the first device does not change, the first temperature parameter is equivalent to a constant in the target adjustment function. However, when the status parameter set of the first device changes, the value of the first temperature parameter needs to be re-determined based on a changed status parameter set, so that heat dissipating efficiency output by the target adjustment function meets an actual temperature status of the heat emitting element. The heat dissipating efficiency output by the target adjustment function can be adjusted even when the detected temperature has not changed, so that the heat dissipating efficiency of the heat dissipating element can be adjusted in advance to meet the heat dissipating requirement of the heat emitting element at the actual temperature.

303. Determine a value of a second temperature parameter in the target adjustment function based on the status parameter set.

In this embodiment, similar to the first temperature parameter, the second temperature parameter is also a parameter in the target adjustment function. When the status parameter set of the first device does not change, the second temperature parameter is also equivalent to a constant in the target adjustment function. However, when the status parameter set of the first device changes, the value of the second temperature parameter needs to be re-determined based on a changed status parameter set. After the values of the first temperature parameter and the second temperature parameter are determined based on the status parameter set, heat dissipating efficiency output by the target adjustment function can meet an actual temperature status of the heat emitting element. The heat dissipating efficiency output by the target adjustment function can be adjusted even when the detected temperature has not changed. This resolves a problem that the heat dissipating efficiency of the heat dissipating element cannot be adjusted in time because the detected temperature cannot reflect the actual temperature of the heat emitting element in real time after a running status parameter of the first device changes.

304. Determine the heat dissipating efficiency of the heat dissipating element based on the value of the first temperature parameter, the value of the second temperature parameter, and the detected temperature.

In this embodiment, because the target adjustment function is a function with the detected temperature being an independent variable and the heat dissipating efficiency of the heat dissipating element being a dependent variable, after the value of the first temperature parameter and the value of the second temperature parameter are determined, the detected temperature may be used as an input for the target adjustment function, to output the heat dissipating efficiency of the heat dissipating element.

305. Control running of the heat dissipating element based on the heat dissipating efficiency of the heat dissipating element.

In this embodiment, after the heat dissipating efficiency of the heat dissipating element is determined based on the value of the first temperature parameter, the value of the second temperature parameter, and the detected temperature by using the target adjustment function, a corresponding control instruction may be generated based on the heat dissipating efficiency, and the control instruction may be sent to the heat dissipating element, to control the heat dissipating element to run based on the heat dissipating efficiency.

In this embodiment, the values of the first temperature parameter and the second temperature parameter in the target adjustment function are determined based on the status parameter set of the first device, that is, when the running status parameter of the first device changes, the values of the first temperature parameter and the second temperature parameter in the target adjustment function also change accordingly, so that the target adjustment function can output correct heat dissipating efficiency of the heat dissipating element when the detected temperature does not change, to control the heat dissipating element to run based on heat dissipating efficiency required in an actual condition. Therefore, the heat dissipating efficiency of the heat dissipating element is adjusted in advance without a need to wait for hysteresis duration required for changing of the detected temperature, thereby resolving a problem that the heat dissipating efficiency of the heat dissipating element cannot be adjusted in time because after the running status parameter of the first device changes, an actual temperature of the heat emitting element in the first device rapidly changes, but the detected temperature cannot change in real time with the actual temperature of the heat emitting element. This can effectively protect the heat emitting element in the first device from running at a high temperature and being burnt because the temperature of the heat emitting element rapidly rises, but the heat dissipating efficiency of the heat dissipating element is not high enough; and can also reduce the heat dissipating efficiency of the heat dissipating element in time when the actual temperature of the heat emitting element rapidly drops, thereby helping increase a life of the heat dissipating element. In this solution, the values of the first temperature parameter and the second temperature parameter in the target adjustment function may be updated in real time when the first device is in different working conditions, that is, has different running status parameters. This resolves a problem that an adjustment rate of the heat dissipating efficiency of the heat dissipating element cannot keep pace with a change rate of the actual temperature of the heat emitting element after the running status parameter changes. In addition, the heat dissipating efficiency of the heat dissipating element is calculated by using the target adjustment function, so that continuous adjustment can be performed in real time based on the detected temperature. This implements smooth heat dissipating efficiency switching.

In a specific embodiment, the first device in the foregoing embodiment may be a high-power device such as an inverter or a transformer. A switch chip included in the inverter corresponds to the heat emitting element in the first device. The temperature detection element may be specifically an NTC resistor, configured to detect a temperature of the switch chip. The detected temperature of the switch chip may be referred to as an NTC temperature. For ease of understanding, the following provides further detailed descriptions with reference to a specific running status parameter by using an example in which the first device is an inverter.

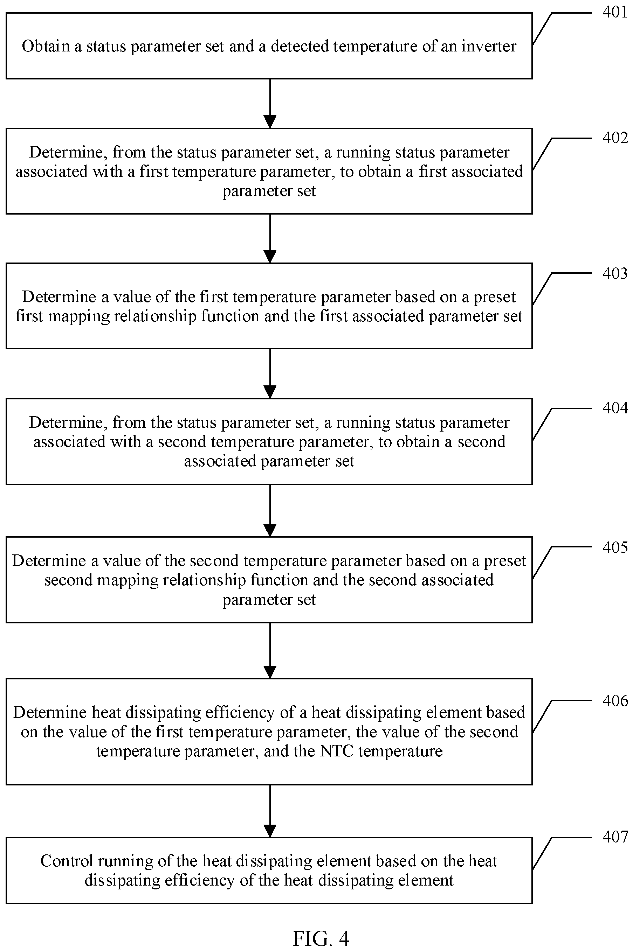

FIG. 4 is a schematic diagram of another embodiment of a heat dissipating element control method according to an embodiment of this application.

As shown in FIG. 4, this embodiment may include the following steps.

401. Obtain a status parameter set and a detected temperature of an inverter.

In this embodiment, the inverter corresponds to the foregoing first device, and the status parameter set of the inverter may specifically include a direct current bus voltage, an output current, a switching frequency, a modulation scheme parameter, a power factor, and the like. The heat emitting element in the foregoing first device corresponds to a switch chip in the inverter in this embodiment, and the detected temperature in this embodiment is a detected temperature of the switch chip. Specific content of step 401 is similar to the specific content of step 301. For details, refer to the details in step 301. The details are not described herein again.

402. Determine, from the status parameter set, a running status parameter associated with a first temperature parameter, to obtain a first associated parameter set.

In this embodiment, the status parameter set of the inverter may include a plurality of types of running status parameters. However, only a part of the running status parameters may be strongly associated with the first temperature parameter. Therefore, the associated part of the running status parameters needs to be determined from the status parameter set, to obtain the first associated parameter set.

403. Determine a value of the first temperature parameter based on a preset first mapping relationship function and the first associated parameter set.

In this embodiment, when the obtained first associated parameter set of the inverter changes, a power consumption status of the inverter is affected, and further actual temperature change trends of the inverter and the switch chip in the inverter are affected. To match an actual temperature change trend of the switch chip and enable a target adjustment function to output heat dissipating efficiency that is of a heat dissipating element and that corresponds to an actual temperature of the switch chip, the first temperature parameter needs to be adjusted. Therefore, there is an indirect impact relationship between the first associated parameter set and the first temperature parameter. Therefore, in the technical solution of this application, the first mapping relationship function is pre-built based on the indirect impact relationship between the first associated parameter set and the first temperature parameter, so that the indirect impact relationship between the first associated parameter set and the first temperature parameter is converted into a direct mapping relationship between the first associated parameter set and the first temperature parameter. Based on the preset first mapping relationship, the value of the first temperature parameter may be directly determined based on the first associated parameter set.

Specifically, in the preset first mapping relationship function, the value of the first temperature parameter is a difference between a preset maximum value of the first temperature parameter and a first adjustment value, and the first adjustment value is obtained by performing weighted summation on values of all running status parameters in the first associated parameter set based on weight values respectively corresponding to all the running status parameters in the first associated parameter set. The preset maximum value of the first temperature parameter is used to set an upper limit of the value of the first temperature parameter, to optimize a value range of the first temperature parameter.

Optionally, the first associated parameter set specifically includes five types of parameters: the direct current bus voltage, the output current, the switching frequency, the modulation scheme parameter, and the power factor. Correspondingly, a formula of the first mapping relationship function may be specifically as follows:

$$T_{full} = T_{max} - [\alpha_1 \cdot i + \alpha_2 \cdot u + \alpha_3 \cdot pwm + \alpha_4 \cdot f_s + \alpha_5 \cdot (1 - |pf|)],$$

where $T_{full}$ is the first temperature parameter, $T_{max}$ is the preset maximum value of the first temperature parameter, i is the output current, u is the direct current bus voltage, pwm is the modulation scheme parameter, the modulation scheme parameter may be equal to 0 or 1, $f_s$ is the switching frequency, and pf is the power factor. When pwm = 0, a modulation scheme of the inverter is a first modulation scheme, and the first modulation scheme is specifically a discontinuous pulse width modulation (DPWM) scheme. When pwm=1, a modulation scheme of the inverter is a second modulation scheme, and the second modulation scheme is specifically a sine pulse width modulation (SPWM) scheme. Preset $\alpha_1$, $\alpha_2$, $\alpha_3$, $\alpha_4$, and $\alpha_5$ are respectively weight values corresponding to the output current, the direct current bus voltage, the modulation scheme parameter, the switching frequency, and the power factor. Because the output current, the direct current bus voltage, the modulation scheme parameter, the switching frequency, and the power factor affect power consumption of the inverter to different degrees, the output current, the direct current bus voltage, the modulation scheme parameter, the switching frequency, and the power factor also affect the value of the first temperature parameter to different degrees. $\alpha_1$, $\alpha_2$, $\alpha_3$, $\alpha_4$, and $\alpha_5$ are respectively used to indicate degrees to which the output current, the direct current bus voltage, the modulation scheme parameter, the switching frequency, and the power factor affect the value of the first temperature parameter.

$\alpha_1$, $\alpha_2$, $\alpha_3$, $\alpha_4$, and $\alpha_5$ are also associated with models of the heat dissipating element and a power module. Values of $\alpha_1$, $\alpha_2$, $\alpha_3$, $\alpha_4$, and $\alpha_5$ may be set based on various types of configurations of the inverter, to generate a corresponding weight value table. In an actual application, corresponding weight values may be selected based on a user instruction, and the user instruction is entered by the user based on an actual configuration status of the inverter.

404. Determine, from the status parameter set, a running status parameter associated with a second temperature parameter, to obtain a second associated parameter set.

In this embodiment, the status parameter set of the inverter may include a plurality of types of running status parameters. However, only a part of the running status parameters may be strongly associated with the second temperature parameter. Therefore, the strongly associated part of the running status parameters needs to be determined from the status parameter set, to obtain the second associated parameter set.

405. Determine a value of the second temperature parameter based on a preset second mapping relationship function and the second associated parameter set.

In this embodiment, when the second associated parameter set of the inverter changes, a power consumption status of the inverter is affected, and further actual temperature change trends of the inverter and the switch chip in the inverter are affected. To match an actual temperature change trend of the switch chip and enable the target adjustment function to output heat dissipating efficiency that is of the heat dissipating element and that corresponds to an actual temperature of the switch chip, the second temperature parameter needs to be adjusted. Therefore, there is an indirect impact relationship between the second associated parameter set and the second temperature parameter. Therefore, in the technical solution of this application, the second mapping relationship function is pre-built based on the indirect impact relationship between the second associated parameter set and the second temperature parameter, so that the indirect impact relationship between the second associated parameter set and the second temperature parameter is converted into a direct mapping relationship between the second associated parameter set and the second temperature parameter. Based on the preset second mapping relationship, the value of the second temperature parameter may be directly determined based on the second associated parameter set.

Specifically, in the preset second mapping relationship function, the value of the second temperature parameter is a difference between a preset maximum value of the second temperature parameter and a second adjustment value, the second adjustment value is associated with a preset adjustment threshold and a ratio of a value of a target running status parameter to a rated value corresponding to the target running status parameter, and the target status parameter is a running status parameter in the second associated parameter set. The preset maximum value of the second temperature parameter is used to set an upper limit of the value of the second temperature parameter, to optimize a value range of the second temperature parameter. The preset adjustment threshold is used to control a value change range of the second temperature parameter.

Optionally, the target status parameter in the second associated parameter set is specifically the output current of the inverter. The running status parameter is a running status parameter that affects the power consumption of the inverter to a greatest degree, and therefore the running status parameter also affects the value of the second temperature parameter to a greatest degree. A formula of the second mapping relationship function may be specifically as follows:

$$T_{start} = T_0 - T_{adjust} \cdot \left(\frac{i}{i_N}\right)^2,$$

where $T_{start}$ is the second temperature parameter, $T_0$ is the preset maximum value of the second temperature parameter, $T_{adjust}$ is the preset adjustment threshold, i is the output current of the inverter, and $i_N$ is a rated output current of the inverter. Because $0 \leq i \leq i_N$, a value range of $\left(\frac{i}{i_N}\right)^2$ is from 0 to 1. Therefore, the maximum value of $T_{start}$ is $T_0$, and a minimum value of $T_{start}$ is $(T_0 - T_{adjust})$, that is, a value adjustment range of $T_{start}$ is $T_{adjust}$. Values of $T_0$ and $T_{adjust}$ may be set based on an actual case, and are not specifically limited in this application.

406. Determine heat dissipating efficiency of the heat dissipating element based on the value of the first temperature parameter, the value of the second temperature parameter, and an NTC temperature (namely, the detected temperature).

In this embodiment, after the values of the first temperature parameter and the second temperature parameter are determined by using the first mapping relationship function and the second mapping relationship function, the heat dissipating efficiency of the heat dissipating element may be determined based on the values of the first temperature parameter and the second temperature parameter, and the NTC temperature.

Optionally, to help reduce building difficulty of the target adjustment function and help calculate the heat dissipating efficiency, the target adjustment function may be built as a linear function of one variable for which the NTC temperature is used as an independent variable and the heat dissipating efficiency is used as a dependent variable. A formula of the target adjustment function may be specifically as follows:

$$D_{ref} = D_{start} + (D_{full} - D_{start}) \cdot \frac{T_{NTC} - T_{start}}{T_{full} - T_{start}},$$

where $D_{ref}$ is the heat dissipating efficiency of the heat dissipating element, $D_{full}$ is a preset first heat dissipating efficiency threshold, $T_{NTC}$ is the NTC temperature, the first heat dissipating efficiency threshold is maximum heat dissipating efficiency that can be achieved during running of the heat dissipating element, $D_{start}$ is a preset second heat dissipating efficiency threshold, and the second heat dissipating efficiency threshold is minimum heat dissipating efficiency that is achieved when the heat dissipating element starts to run. It should be noted that, in the target adjustment function, $T_{full} > T_{start}$, and correspondingly $D_{full} > D_{start}$. When $T_{NTC} \geq T_{start}$, $D_{ref} \geq D_{start}$, and the heat dissipating element can start to operate. When $T_{NTC} \geq T_{full}$, $D_{ref} \geq D_{full}$, and the heat dissipating element runs based on the maximum heat dissipating efficiency (that is, the first heat dissipating efficiency threshold).

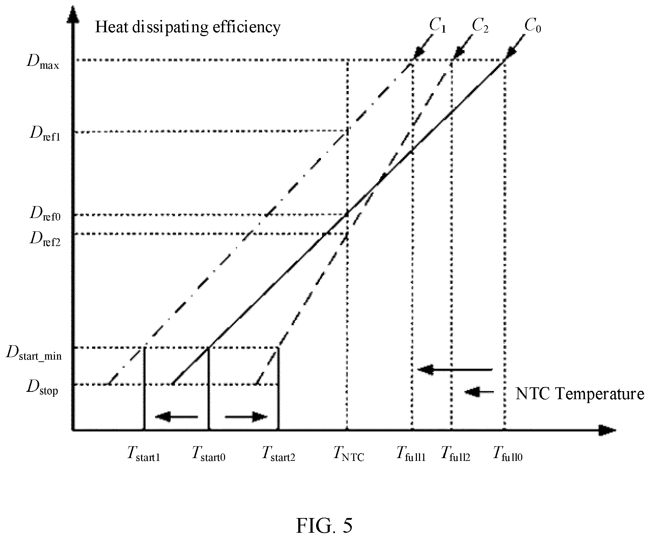

Because the first heat dissipating efficiency threshold and the second heat dissipating efficiency threshold are both preset values, when the obtained status parameter set of the inverter changes, the heat dissipating efficiency of the heat dissipating element can be determined provided that the NTC temperature is obtained and the values of the first temperature parameter and the second temperature parameter are determined. As an example, referring to FIG. 5, $C_0$ is a function curve corresponding to the target adjustment function when the status parameter set has not changed, and $C_1$ and $C_2$ are respectively function curves corresponding to the target adjustment function after the values of the first temperature parameter and the second temperature parameter correspondingly change after the status parameter set changes in two cases. It can be seen from FIG. 5 that, after the status parameter set changes, when the NTC temperature has not changed, $C_0$, $C_1$, and $C_2$ output different heat dissipating efficiency, and heat dissipating efficiency output by $C_1$ and $C_2$ can meet heat dissipating requirements of the switch chip at actual temperatures to greater degrees.

407. Control running of the heat dissipating element based on the heat dissipating efficiency of the heat dissipating element.

In this embodiment, content of step 407 is similar to the content of step 305. For details, refer to the details in step 305. The details are not described herein again.

In a specific embodiment, to prevent the NTC temperature from fluctuating around $T_{start}$ to cause the heat dissipating element to frequently start and stop, a hysteresis control mechanism may be added to starting and stopping control of the heat dissipating element, that is, a third heat dissipating efficiency threshold $D_{stop}$ is preset. The third heat dissipating efficiency threshold is less than the second heat dissipating efficiency threshold. When $D_{ref}$ output by the target adjustment function is greater than $D_{start}$, the heat dissipating element can start to run. However, after the heat dissipating element starts to run, only when $D_{ref} < D_{stop}$, the heat dissipating element can stop running. Additional losses caused by frequent starting and stopping of the heat dissipating element to the heat dissipating element can be effectively reduced by using the hysteresis control mechanism.

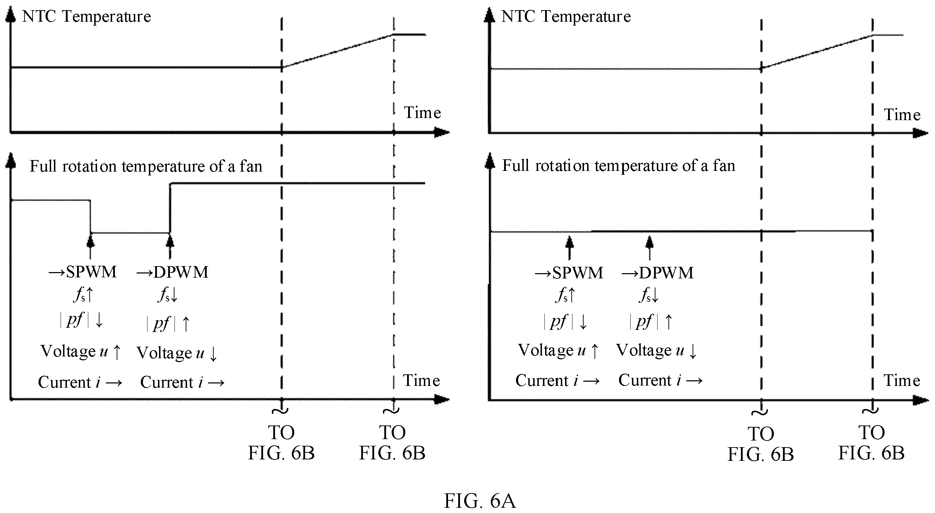

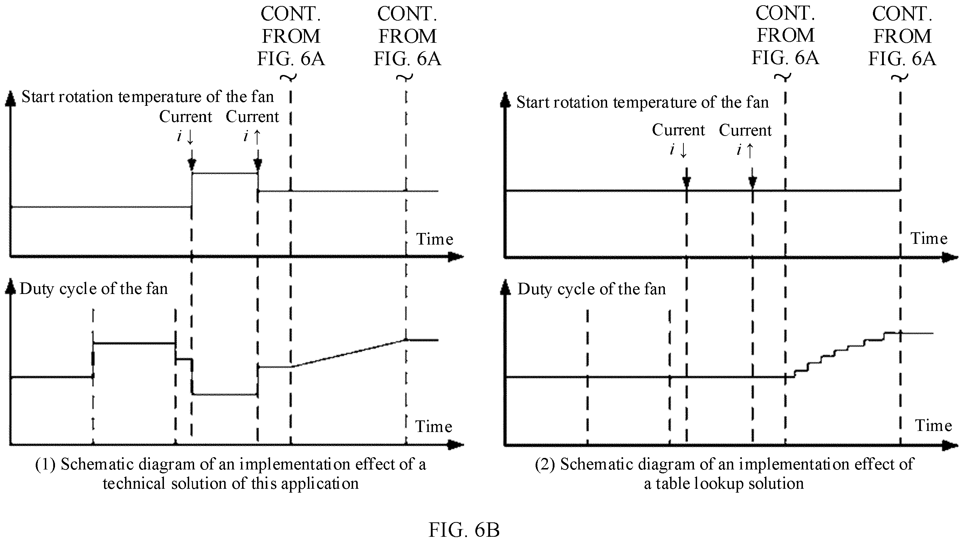

To more intuitively represent an actual effect brought by the technical solution in this embodiment, refer to FIG. 6A and FIG. 6B.

As shown in FIG. 6A and FIG. 6B, when the obtained status parameter set of the inverter changes, because an NTC resistor has hysteresis in detecting the actual temperature of the switch chip, the NTC temperature cannot reflect an actual temperature change status of the switch chip in time. For example, the heat dissipating element is a combination of a heat dissipating fan and a heat sink. In FIG. 6A and FIG. 6B, a full rotation temperature of the fan corresponds to the first temperature parameter in the foregoing embodiment, a start rotation temperature of the fan corresponds to the second temperature parameter in the foregoing embodiment, and a duty cycle of the fan corresponds to the heat dissipating efficiency of the heat dissipating element in the foregoing embodiment.

According to the technical solution provided in this embodiment, when the obtained status parameter set (including i, u, pwm, $f_s$, and |pf|) of the inverter changes, the start rotation temperature of the fan and the full rotation temperature of the fan are updated based on the change of the status parameter set, so that a duty cycle that is of the fan and that corresponds to the actual temperature of the switch chip is output when the NTC temperature does not change, thereby ensuring safe running of the switch chip and also helping increase a service life of the heat dissipating element. When the duty cycle of the fan is adjusted by using a table lookup method, even when a running status parameter of the inverter changes, the start rotation temperature of the fan and the full rotation temperature of the fan do not change. When the NTC temperature does not change, a duty cycle that is of the fan and that is found based on a preset mapping relationship table does not change, and until the NTC temperature starts to change, the duty cycle of the fan starts to change stepwise. When a quantity of points in the preset mapping relationship table is set to be excessively small, a process of switching between different duty cycles of the fan is not smooth. For the switch chip, when the running status parameter changes, the actual temperature of the switch chip has changed. However, in this method, the duty cycle of the fan can be adjusted based on only a change in the NTC temperature that has a hysteresis problem, and therefore it is clearly that safe running of the switch chip cannot be ensured. In the technical solution of this application, an output duty cycle of the fan can be adjusted in advance only by adjusting values of the first temperature parameter and the second temperature parameter, to meet a heat dissipating requirement of the switch chip at the actual temperature.

The foregoing describes the heat dissipating element control method provided in the embodiments of this application, and the following describes a control apparatus provided in the embodiments of this application.

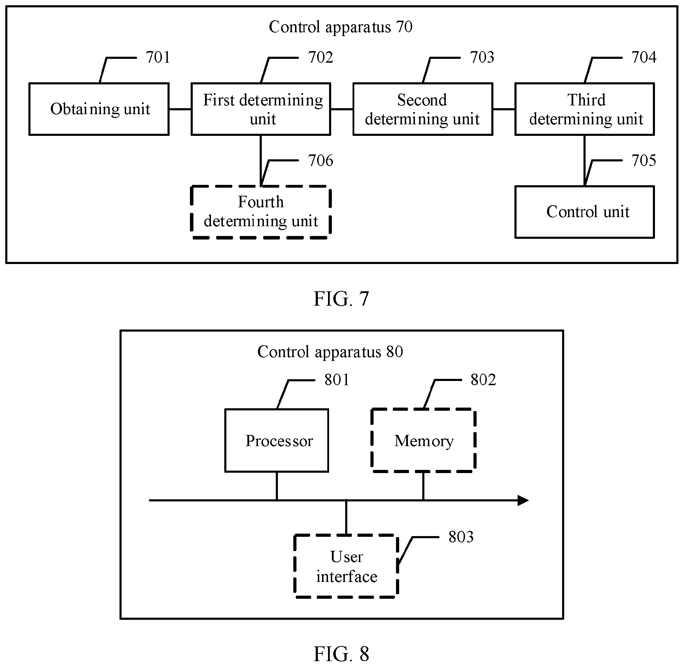

FIG. 7 is a schematic diagram of an embodiment of a control apparatus according to an embodiment of this application.

As shown in FIG. 7, a control apparatus 70 provided in this embodiment of this application may include:

an obtaining unit 701, configured to obtain a status parameter set and a detected temperature of a first device, where the status parameter set includes at least one running status parameter, and the at least one running status parameter is a parameter that affects a temperature of the first device when the first device runs;

a first determining unit 702, configured to determine a value of a first temperature parameter in a target adjustment function based on the status parameter set, where the target adjustment function is a function with the detected temperature being an independent variable and heat dissipating efficiency of a heat dissipating element being a dependent variable;

a second determining unit 703, configured to determine a value of a second temperature parameter in the target adjustment function based on the status parameter set;

a third determining unit 704, configured to determine the heat dissipating efficiency of the heat dissipating element based on the value of the first temperature parameter, the value of the second temperature parameter, and the detected temperature; and

a control unit 705, configured to control running of the heat dissipating element based on the heat dissipating efficiency of the heat dissipating element.

Optionally, as a possible design, the first determining unit 702 is specifically configured to determine, from the status parameter set, a running status parameter associated with the first temperature parameter, to obtain a first associated parameter set; and

the first determining unit 702 is further specifically configured to determine the value of the first temperature parameter based on a preset first mapping relationship function and the first associated parameter set, where the first mapping relationship function is used to represent a mapping relationship between the running status parameter in the first associated parameter set and the first temperature parameter.

Optionally, as a possible design, in the first mapping relationship function, the value of the first temperature parameter is a difference between a preset maximum value of the first temperature parameter and a first adjustment value, and the first adjustment value is obtained by performing weighted summation on values of all running status parameters in the first associated parameter set based on weight values respectively corresponding to all the running status parameters in the first associated parameter set.

Optionally, as a possible design, the control apparatus 70 may further include:

a fourth determining unit 706, configured to determine, based on a user instruction, the weight values respectively corresponding to all the running status parameters in the first associated parameter set.

Optionally, as a possible design, the second determining unit 703 is specifically configured to determine, from the status parameter set, a running status parameter associated with the second temperature parameter, to obtain a second associated parameter set; and

the second determining unit 703 is further specifically configured to determine the value of the second temperature parameter based on a preset second mapping relationship function and the second associated parameter set, where the second mapping relationship function is used to represent a mapping relationship between the running status parameter in the second associated parameter set and the second temperature parameter.

Optionally, as a possible design, in the second mapping relationship function, the value of the second temperature parameter is a difference between a preset maximum value of the second temperature parameter and a second adjustment value, the second adjustment value is associated with a preset adjustment threshold and a ratio of a value of a target running status parameter to a rated value corresponding to the target running status parameter, and the target status parameter is a running status parameter in the second associated parameter set.

Optionally, as a possible design, when the first device is an inverter, the status parameter set may include a direct current bus voltage, an output current, a switching frequency, a modulation scheme parameter, and a power factor.

FIG. 8 is a schematic diagram of another embodiment of a control apparatus according to an embodiment of this application.

As shown in FIG. 8, a control apparatus 80 provided in this embodiment of this application may include one or more processors 801. Optionally, the control apparatus 80 may further include a memory 802. The processor 801 and the memory 802 are connected to each other by using a communications bus.

The processor 801 may be a general-purpose central processing unit (CPU), a microprocessor, an ASIC, or one or more integrated circuits for controlling program execution of the solutions of this application.

The memory 802 may be a read-only memory (ROM) or another type of static storage device that can store static information and an instruction, or a random access memory (RAM) or another type of dynamic storage device that can store information and an instruction; or may be an electrically erasable programmable read-only memory (EEPROM), a compact disc read-only memory (CD-ROM) or another compact disc storage, an optical disc storage (including a compact disc, a laser disc, an optical disc, a digital versatile disc, and a Blu-ray disc, and the like), a magnetic disk storage medium or another magnetic storage device, or any other medium that can be used to carry or store expected program code in a form of an instruction or a data structure and that is accessible by a computer. However, the memory 802 is not limited thereto. The memory 802 may exist independently and is connected to the processor 801 by using the bus. Alternatively, the memory 802 may be integrated with the processor 801.

The memory 802 is configured to store application program code for executing the solutions of this application, where the execution is controlled by the processor 801. The processor 801 is configured to execute the application program code stored in the memory 802.

During specific implementation, the processor 801 may include one or more CPUs, and each CPU may be a single-core (single-core) processor, or may be a multi-core (multi-Core) processor. The processor herein may be one or more devices, circuits, and/or processing cores for processing data (such as a computer program instruction).

Optionally, the control apparatus 80 may further include a user interface 803.

The user interface 803 may include a display and a tapping device such as a keyboard, a mouse touchpad, or a touchscreen. For example, the control apparatus includes a display and a keyboard. The keyboard may be configured to obtain a user instruction, to control the control apparatus to execute a user command. The display may be configured to display specific values of the foregoing first temperature parameter, the second temperature parameter, and various types of preset parameter, and may be further configured to display a function curve of a target adjustment function.

As another form of the embodiments, a computer-readable storage medium is provided. The computer-readable storage medium stores an instruction. When the instruction is executed, the method executed by the control apparatus in the foregoing method embodiment is executed.

As another form of the embodiments, a computer program product including instructions is provided. When the instructions are executed, the method executed by the control apparatus in the foregoing method embodiment is executed.

All or some of the foregoing embodiments may be implemented by using software, hardware, firmware, or any combination thereof. When software is used to implement the embodiments, the embodiments may be implemented completely or partially in a form of a computer program product.

The computer program product includes one or more computer instructions. When the computer program instructions are loaded and executed on a computer, the procedure or functions according to the embodiments of this application are all or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid state disk (solid state disk, SSD)), or the like.

A person of ordinary skill in the art may understand that all or some of the steps of the methods in the foregoing embodiments may be implemented by a program by instructing related hardware. The program may be stored in a computer-readable storage medium. The storage medium may include a ROM, a RAM, a magnetic disk, an optical disc, or the like.

The foregoing describes in detail the heat dissipating element control method and the control apparatus provided in the embodiments of this application. The principle and implementations of this application are described herein by applying specific examples. The foregoing description of the embodiments is merely provided to help understand the method and core ideas of this application. In addition, a person of ordinary skill in the art can make variations in terms of both the specific implementations and application scopes based on the ideas of this application. In conclusion, the content of this specification shall not be construed as a limitation to this application.

**Claims**

1.  A heat dissipating element control method, comprising:

    Obtaining (301) a status parameter set and a detected temperature of a first device, wherein the status parameter set comprises at least one running status parameter, the at least one running status parameter is a parameter that affects a temperature of the first device when the first device runs, the first device is an inverter, and the status parameter set comprises a direct current bus voltage, an output current, a switching frequency, a modulation scheme parameter, and a power factor;
    wherein the method further comprises:

    determining (304) the heat dissipating efficiency of the heat dissipating element based on a value of a first temperature parameter, a value of a second temperature parameter, and the detected temperature, wherein the first temperature parameter is in a target adjustment function, the value of the first temperature parameter is based on the status parameter set, the target adjustment function is a function with the detected temperature being an independent variable and heat dissipating efficiency of a heat dissipating element being a dependent variable, the second temperature parameter is in a target adjustment function, and the value of the second temperature parameter is based on the status parameter set; and
    controlling (305) running of the heat dissipating element based on the heat dissipating efficiency of the heat dissipating element.

2.  The control method according to claim 1, wherein the determining a value of a first temperature parameter in a target adjustment function based on the status parameter set comprises:

    determining, from the status parameter set, a running status parameter associated with the first temperature parameter, to obtain a first associated parameter set; and
    determining the value of the first temperature parameter based on a preset first mapping relationship function and the first associated parameter set, wherein the first mapping relationship function is used to represent a mapping relationship between the running status parameter in the first associated parameter set and the first temperature parameter.

3. The control method according to claim 2, wherein in the first mapping relationship function, the value of the first temperature parameter is a difference between a preset maximum value of the first temperature parameter and a first adjustment value, and the first adjustment value is obtained by performing weighted summation on values of all running status parameters in the first associated parameter set based on weight values respectively corresponding to all the running status parameters in the first associated parameter set.

4. The control method according to claim 3, wherein the control method further comprises:
   determining, based on a user instruction, the weight values respectively corresponding to all the running status parameters in the first associated parameter set.

5. The control method according to any one of claims 1 to 4, wherein the determining a value of a second temperature parameter in the target adjustment function based on the status parameter set comprises:

   determining, from the status parameter set, a running status parameter associated with the second temperature parameter, to obtain a second associated parameter set; and
   determining the value of the second temperature parameter based on a preset second mapping relationship function and the second associated parameter set, wherein the second mapping relationship function is used to represent a mapping relationship between the running status parameter in the second associated parameter set and the second temperature parameter.

6. The control method according to claim 5, wherein in the second mapping relationship function, the value of the second temperature parameter is a difference between a preset maximum value of the second temperature parameter and a second adjustment value, the second adjustment value is associated with a preset adjustment threshold and a ratio of a value of a target running status parameter to a rated value corresponding to the target running status parameter, and the target status parameter is a running status parameter in the second associated parameter set.

7. A control apparatus (70), comprising:

   an obtaining unit (701), configured to obtain a status parameter set and a detected temperature of a first device, wherein the status parameter set comprises at least one running status parameter, the at least one running status parameter is a parameter that affects a temperature of the first device when the first device runs, the first device is an inverter, and the status parameter set comprises a direct current bus voltage, an output current, a switching frequency, a modulation scheme parameter, and a power factor; and
   a first determining unit (702), configured to obtain a value of a first temperature parameter in a target adjustment function based on the status parameter set, wherein the target adjustment function is a function with the detected temperature being an independent variable and heat dissipating efficiency of a heat dissipating element being a dependent variable;
   wherein the control apparatus (70) further comprises:

      a second determining unit (703), configured to obtain a value of a second temperature parameter in the target adjustment function based on the status parameter set;
      a third determining unit (704), configured to determine the heat dissipating efficiency of the heat dissipating element based on the value of the first temperature parameter, the value of the second temperature parameter, and the detected temperature; and
      a control unit (705), configured to control running of the heat dissipating element based on the heat dissipating efficiency of the heat dissipating element.

8. The control apparatus (70) according to claim 7, wherein

   the first determining unit (702) is specifically configured to determine, from the status parameter set, a running status parameter associated with the first temperature parameter, to obtain a first associated parameter set; and
   the first determining unit (702) is further specifically configured to determine the value of the first temperature parameter based on a preset first mapping relationship function and the first associated parameter set, wherein the first mapping relationship function is used to represent a mapping relationship between the running status parameter in the first associated parameter set and the first temperature parameter.

9. The control apparatus (70) according to claim 8, wherein in the first mapping relationship function, the value of the first temperature parameter is a difference between a preset maximum value of the first temperature parameter and a first adjustment value, and the first adjustment value is obtained by performing weighted summation on values of all running status parameters in the first associated parameter set based on weight values respectively corresponding to all the running status parameters in the first associated parameter set.

10. The control apparatus (70) according to claim 9, wherein the control apparatus (70) further comprises:
a fourth determining unit (706), configured to determine, based on a user instruction, the weight values respectively corresponding to all the running status parameters in the first associated parameter set.

11. The control apparatus (70) according to any one of claims 7 to 10, wherein

the second determining unit (703) is specifically configured to determine, from the status parameter set, a running status parameter associated with the second temperature parameter, to obtain a second associated parameter set; and
the second determining unit (703) is further specifically configured to determine the value of the second temperature parameter based on a preset second mapping relationship function and the second associated parameter set, wherein the second mapping relationship function is used to represent a mapping relationship between the running status parameter in the second associated parameter set and the second temperature parameter.

12. The control apparatus (70) according to claim 11, wherein in the second mapping relationship function, the value of the second temperature parameter is a difference between a preset maximum value of the second temperature parameter and a second adjustment value, the second adjustment value is associated with a preset adjustment threshold and a ratio of a value of a target running status parameter to a rated value corresponding to the target running status parameter, and the target status parameter is a running status parameter in the second associated parameter set.

13. A control apparatus (80), comprising a processor (801), wherein the processor (801) is coupled to a memory (802), the memory (802) is configured to store a computer program or instructions, and the processor (801) is configured to execute the computer program or the instructions in the memory (802), to enable the control apparatus (80) to execute the control method according to any one of claims 1 to 6.

14. A computer-readable storage medium, storing a computer program, wherein the control method according to any one of claims 1 to 6 is implemented when the program is executed.

**Patentansprüche**

1. Steuerverfahren für ein Wärmeableitungselement, umfassend:

Erhalten (301) eines Statusparametersatzes und einer erfassten Temperatur einer ersten Einrichtung, wobei der Statusparametersatz mindestens einen Betriebsstatusparameter umfasst, wobei der mindestens eine Betriebsstatusparameter ein Parameter ist, der eine Temperatur der ersten Einrichtung beeinflusst, wenn die erste Einrichtung in Betrieb ist, die erste Einrichtung ein Wechselrichter ist und der Statusparametersatz eine Gleichstrombusspannung, einen Ausgangsstrom, eine Schaltfrequenz, einen Modulationsschemaparameter und einen Leistungsfaktor umfasst;
wobei das Verfahren ferner Folgendes umfasst:

Bestimmen (304) der Wärmeableitungseffizienz des Wärmeableitungselements basierend auf einem Wert eines ersten Temperaturparameters, einem Wert eines zweiten Temperaturparameters und der erfassten Temperatur, wobei sich der erste Temperaturparameter in einer Zielanpassungsfunktion befindet, der Wert des ersten Temperaturparameters auf dem Statusparametersatz basiert, die Zielanpassungsfunktion eine Funktion ist, bei der die erfasste Temperatur eine unabhängige Variable und eine Wärmeableitungseffizienz eines Wärmeableitungselements eine abhängige Variable ist, sich der zweite Temperaturparameter in einer Zielanpassungsfunktion befindet und der Wert des zweiten Temperaturparameters auf dem Statusparametersatz basiert; und
Steuern (305) eines Betriebs des Wärmeableitungselements basierend auf der Wärmeableitungseffizienz des Wärmeableitungselements.

**2.** Steuerverfahren nach Anspruch 1, wobei das Bestimmen eines Werts eines ersten Temperaturparameters in einer Zielanpassungsfunktion basierend auf dem Statusparametersatz Folgendes umfasst:

Bestimmen, aus dem Statusparametersatz, eines Betriebsstatusparameters, der dem ersten Temperaturparameter zugeordnet ist, um einen ersten zugeordneten Parametersatz zu erhalten; und
Bestimmen des Werts des ersten Temperaturparameters basierend auf einer voreingestellten ersten Abbildungsbeziehungsfunktion und dem ersten zugeordneten Parametersatz, wobei die erste Abbildungsbeziehungsfunktion verwendet wird, um eine Abbildungsbeziehung zwischen dem Betriebsstatusparameter in dem ersten zugeordneten Parametersatz und dem ersten Temperaturparameter darzustellen.

**3.** Steuerverfahren nach Anspruch 2, wobei in der ersten Abbildungsbeziehungsfunktion der Wert des ersten Temperaturparameters eine Differenz zwischen einem voreingestellten Maximalwert des ersten Temperaturparameters und einem ersten Anpassungswert ist und der erste Anpassungswert durch Durchführen einer gewichteten Summierung von Werten sämtlicher Betriebsstatusparameter in dem ersten zugeordneten Parametersatz basierend auf Gewichtungswerten, die jeweils sämtlichen Betriebsstatusparametern in dem ersten zugeordneten Parametersatz entsprechen, erhalten wird.

**4.** Steuerverfahren nach Anspruch 3, wobei das Steuerverfahren ferner Folgendes umfasst:
Bestimmen, basierend auf einer Benutzeranweisung, der Gewichtungswerte, die jeweils sämtlichen Betriebsstatusparametern in dem ersten zugeordneten Parametersatz entsprechen.

**5.** Steuerverfahren nach einem der Ansprüche 1 bis 4, wobei das Bestimmen eines Werts eines zweiten Temperaturparameters in der Zielanpassungsfunktion basierend auf dem Statusparametersatz Folgendes umfasst:

Bestimmen, aus dem Statusparametersatz, eines Betriebsstatusparameters, der dem zweiten Temperaturparameter zugeordnet ist, um einen zweiten zugeordneten Parametersatz zu erhalten; und
Bestimmen des Werts des zweiten Temperaturparameters basierend auf einer voreingestellten zweiten Abbildungsbeziehungsfunktion und dem zweiten zugeordneten Parametersatz, wobei die zweite Abbildungsbeziehungsfunktion verwendet wird, um eine Abbildungsbeziehung zwischen dem Betriebsstatusparameter in dem zweiten zugeordneten Parametersatz und dem zweiten Temperaturparameter darzustellen.

**6.** Steuerverfahren nach Anspruch 5, wobei in der zweiten Abbildungsbeziehungsfunktion der Wert des zweiten Temperaturparameters eine Differenz zwischen einem voreingestellten Maximalwert des zweiten Temperaturparameters und einem zweiten Anpassungswert ist, der zweite Anpassungswert einem voreingestellten Anpassungsschwellenwert und einem Verhältnis eines Werts eines Zielbetriebsstatusparameters zu einem Nennwert, der dem Zielbetriebsstatusparameter entspricht, zugeordnet ist, und der Zielstatusparameter ein Betriebsstatusparameter in dem zweiten zugeordneten Parametersatz ist.

**7.** Steuervorrichtung (70), umfassend:

eine Erhaltungseinheit (701), die dazu konfiguriert ist, einen Statusparametersatz und eine erfasste Temperatur einer ersten Einrichtung zu erhalten, wobei der Statusparametersatz mindestens einen Betriebsstatusparameter umfasst, wobei der mindestens eine Betriebsstatusparameter ein Parameter ist, der eine Temperatur der ersten Einrichtung beeinflusst, wenn die erste Einrichtung in Betrieb ist, die erste Einrichtung ein Wechselrichter ist und der Statusparametersatz eine Gleichstrombusspannung, einen Ausgangsstrom, eine Schaltfrequenz, einen Modulationsschemaparameter und einen Leistungsfaktor umfasst; und
eine erste Bestimmungseinheit (702), die dazu konfiguriert ist, einen Wert eines ersten Temperaturparameters in einer Zielanpassungsfunktion basierend auf dem Statusparametersatz zu erhalten, wobei die Zielanpassungsfunktion eine Funktion ist, bei der die erfasste Temperatur eine unabhängige Variable und eine Wärmeableitungseffizienz eines Wärmeableitungselements eine abhängige Variable ist;
wobei die Steuervorrichtung (70) ferner Folgendes umfasst:

eine zweite Bestimmungseinheit (703), die dazu konfiguriert ist, einen Wert eines zweiten Temperaturparameters in der Zielanpassungsfunktion basierend auf dem Statusparametersatz zu erhalten;
eine dritte Bestimmungseinheit (704), die dazu konfiguriert ist, die Wärmeableitungseffizienz des Wärmeableitungselements basierend auf dem Wert des ersten Temperaturparameters, dem Wert des zweiten Temperaturparameters und der erfassten Temperatur zu bestimmen; und
eine Steuereinheit (705), die dazu konfiguriert ist, den Betrieb des Wärmeableitungselements basierend auf der Wärmeableitungseffizienz des Wärmeableitungselements zu steuern.

8. Steuervorrichtung (70) nach Anspruch 7, wobei die erste Bestimmungseinheit (702) insbesondere dazu konfiguriert ist, aus dem Statusparametersatz, einen Betriebsstatusparameter, der dem ersten Temperaturparameter zugeordnet ist, zu bestimmen, um einen ersten zugeordneten Parametersatz zu erhalten; und
die erste Bestimmungseinheit (702) ferner insbesondere dazu konfiguriert ist, den Wert des ersten Temperaturparameters basierend auf einer voreingestellten ersten Abbildungsbeziehungsfunktion und dem ersten zugeordneten Parametersatz zu bestimmen, wobei die erste Abbildungsbeziehungsfunktion verwendet wird, um eine Abbildungsbeziehung zwischen dem Betriebsstatusparameter in dem ersten zugeordneten Parametersatz und dem ersten Temperaturparameter darzustellen.

9. Steuervorrichtung (70) nach Anspruch 8, wobei in der ersten Abbildungsbeziehungsfunktion der Wert des ersten Temperaturparameters eine Differenz zwischen einem voreingestellten Maximalwert des ersten Temperaturparameters und einem ersten Anpassungswert ist und der erste Anpassungswert durch Durchführen einer gewichteten Summierung von Werten sämtlicher Betriebsstatusparameter in dem ersten zugeordneten Parametersatz basierend auf Gewichtungswerten, die jeweils sämtlichen Betriebsstatusparametern in dem ersten zugeordneten Parametersatz entsprechen, erhalten wird.

10. Steuervorrichtung (70) nach Anspruch 9, wobei die Steuervorrichtung (70) ferner Folgendes umfasst:
eine vierte Bestimmungseinheit (706), die dazu konfiguriert ist, basierend auf einer Benutzeranweisung, die Gewichtungswerte, die jeweils sämtlichen Betriebsstatusparametern in dem ersten zugeordneten Parametersatz entsprechen, zu bestimmen.

11. Steuervorrichtung (70) nach einem der Ansprüche 7 bis 10, wobei

die zweite Bestimmungseinheit (703) insbesondere dazu konfiguriert ist, aus dem Statusparametersatz, einen Betriebsstatusparameter zu bestimmen, der dem zweiten Temperaturparameter zugeordnet ist, um einen zweiten zugeordneten Parametersatz zu erhalten; und
die zweite Bestimmungseinheit (703) ferner insbesondere dazu konfiguriert ist, den Wert des zweiten Temperaturparameters basierend auf einer voreingestellten zweiten Abbildungsbeziehungsfunktion und dem zweiten zugeordneten Parametersatz zu bestimmen, wobei die zweite Abbildungsbeziehungsfunktion verwendet wird, um eine Abbildungsbeziehung zwischen dem Betriebsstatusparameter in dem zweiten zugeordneten Parametersatz und dem zweiten Temperaturparameter darzustellen.

12. Steuervorrichtung (70) nach Anspruch 11, wobei in der zweiten Abbildungsbeziehungsfunktion der Wert des zweiten Temperaturparameters eine Differenz zwischen einem voreingestellten Maximalwert des zweiten Temperaturparameters und einem zweiten Anpassungswert ist, der zweite Anpassungswert einem voreingestellten Anpassungsschwellenwert und einem Verhältnis eines Werts eines Zielbetriebsstatusparameters zu einem Nennwert, der dem Zielbetriebsstatusparameter entspricht, zugeordnet ist, und der Zielstatusparameter ein Betriebsstatusparameter in dem zweiten zugeordneten Parametersatz ist.

13. Steuervorrichtung (80), umfassend einen Prozessor (801), wobei der Prozessor (801) mit einem Speicher (802) gekoppelt ist, der Speicher (802) dazu konfiguriert ist, ein Computerprogramm oder Anweisungen zu speichern, und der Prozessor (801) dazu konfiguriert ist, das Computerprogramm oder die Anweisungen in dem Speicher (802) auszuführen, um die Steuervorrichtung (80) in die Lage zu versetzen, das Steuerverfahren nach einem der Ansprüche 1 bis 6 auszuführen.

14. Computerlesbares Speichermedium, das ein Computerprogramm speichert, wobei das Steuerverfahren nach einem der Ansprüche 1 bis 6 umgesetzt wird, wenn das Programms ausgeführt wird.

**Revendications**

1. Procédé de commande d'élément de dissipation de chaleur, comprenant :

l'obtention (301) d'un ensemble de paramètres d'état et d'une température détectée d'un premier dispositif, dans lequel l'ensemble de paramètres d'état comprend au moins un paramètre d'état de fonctionnement, l'au moins un paramètre d'état de fonctionnement est un paramètre qui affecte une température du premier dispositif lorsque le premier dispositif fonctionne, le premier dispositif est un onduleur, et l'ensemble de paramètres d'état comprend une tension de bus de courant continu, un courant de sortie, une fréquence de commutation, un paramètre de schéma de modulation et un facteur de puissance ;
dans lequel le procédé comprend en outre :

la détermination (304) de l'efficacité de dissipation de chaleur de l'élément de dissipation de chaleur sur la base d'une valeur d'un premier paramètre de température, d'une valeur d'un second paramètre de température et de la température détectée, dans lequel le premier paramètre de température est dans une fonction de réglage cible, la valeur du premier paramètre de température est basée sur l'ensemble de paramètres d'état, la fonction de réglage cible est une fonction dans laquelle la température détectée est une variable indépendante et une efficacité de dissipation de chaleur d'un élément de dissipation de chaleur est une variable dépendante, le second paramètre de température est dans une fonction de réglage cible, et la valeur du second paramètre de température est basée sur l'ensemble de paramètres d'état ; et
la commande (305) du fonctionnement de l'élément de dissipation de chaleur sur la base de l'efficacité de dissipation de chaleur de l'élément de dissipation de chaleur.

2. Procédé de commande selon la revendication 1, dans lequel la détermination d'une valeur d'un premier paramètre de température dans une fonction de réglage cible sur la base de l'ensemble de paramètres d'état comprend :

la détermination, à partir de l'ensemble de paramètres d'état, d'un paramètre d'état de fonctionnement associé au premier paramètre de température, pour obtenir un premier ensemble de paramètres associés ; et
la détermination de la valeur du premier paramètre de température sur la base d'une première fonction de relation de mappage prédéfinie et du premier ensemble de paramètres associés, dans lequel la première fonction de relation de mappage est utilisée pour représenter une relation de mappage entre le paramètre d'état de fonctionnement dans le premier ensemble de paramètres associés et le premier paramètre de température.

3. Procédé de commande selon la revendication 2, dans lequel, dans la première fonction de relation de mappage, la valeur du premier paramètre de température est une différence entre une valeur maximale prédéfinie du premier paramètre de température et une première valeur de réglage, et la première valeur de réglage est obtenue en exécutant une addition pondérée sur des valeurs de tous les paramètres d'état de fonctionnement dans le premier ensemble de paramètres associés sur la base de valeurs de poids correspondant respectivement à tous les paramètres d'état de fonctionnement dans le premier ensemble de paramètres associés.

4. Procédé de commande selon la revendication 3, dans lequel le procédé de commande comprend en outre :
la détermination, sur la base d'une instruction d'utilisateur, des valeurs de poids correspondant respectivement à tous les paramètres d'état de fonctionnement dans le premier ensemble de paramètres associés.

5. Procédé de commande selon l'une quelconque des revendications 1 à 4, dans lequel la détermination d'une valeur d'un second paramètre de température dans la fonction de réglage cible sur la base de l'ensemble de paramètres d'état comprend :

la détermination, à partir de l'ensemble de paramètres d'état, d'un paramètre d'état de fonctionnement associé au second paramètre de température, pour obtenir un second ensemble de paramètres associés ; et
la détermination de la valeur du second paramètre de température sur la base d'une seconde fonction de relation de mappage prédéfinie et du second ensemble de paramètres associés, dans lequel la seconde fonction de relation de mappage est utilisée pour représenter une relation de mappage entre le paramètre d'état de fonctionnement dans le second ensemble de paramètres associés et le second paramètre de température.

6. Procédé de commande selon la revendication 5, dans lequel, dans la seconde fonction de relation de mappage, la valeur du second paramètre de température est une différence entre une valeur maximale prédéfinie du second paramètre de température et une seconde valeur de réglage, la seconde valeur de réglage est associée avec un seuil de réglage prédéfini et un rapport entre une valeur d'un paramètre d'état de fonctionnement cible et une valeur nominale correspondant au paramètre d'état de fonctionnement cible, et le paramètre d'état de fonctionnement cible est un paramètre d'état de fonctionnement dans le second ensemble de paramètres associés.

7. Appareil de commande (70), comprenant :

une unité d'obtention (701), configurée pour obtenir un ensemble de paramètres d'état et une température détectée d'un premier dispositif, dans lequel l'ensemble de paramètres d'état comprend au moins un paramètre d'état de fonctionnement, l'au moins un paramètre d'état de fonctionnement est un paramètre qui affecte une température du premier dispositif lorsque le premier dispositif fonctionne, le premier dispositif est un onduleur, et l'ensemble de paramètres d'état comprend une tension de bus de courant continu, un courant de sortie, une fréquence de commutation, un paramètre de schéma de modulation et un facteur de puissance ; et
une première unité de détermination (702), configurée pour obtenir une valeur d'un premier paramètre de température dans une fonction de réglage cible sur la base de l'ensemble de paramètres d'état, dans lequel la fonction de réglage cible est une fonction dans laquelle la température détectée est une variable indépendante et une efficacité de dissipation de chaleur d'un élément de dissipation de chaleur est une variable dépendante ;
dans lequel l'appareil de commande (70) comprend en outre :

une deuxième unité de détermination (703), configurée pour obtenir une valeur d'un second paramètre de température dans la fonction de réglage cible sur la base de l'ensemble de paramètres d'état ;
une troisième unité de détermination (704), configurée pour déterminer l'efficacité de dissipation de chaleur de l'élément de dissipation de chaleur sur la base de la valeur du premier paramètre de température, de la valeur du second paramètre de température et de la température détectée ; et
une unité de commande (705), configurée pour commander le fonctionnement de l'élément de dissipation de chaleur sur la base de l'efficacité de dissipation de chaleur de l'élément de dissipation de chaleur.

8.  Appareil de commande (70) selon la revendication 7, dans lequel :

la première unité de détermination (702) est spécifiquement configurée pour déterminer, à partir de l'ensemble de paramètres d'état, un paramètre d'état de fonctionnement associé au premier paramètre de température, pour obtenir un premier ensemble de paramètres associés ; et
la première unité de détermination (702) est en outre spécifiquement configurée pour déterminer la valeur du premier paramètre de température sur la base d'une première fonction de relation de mappage prédéfinie et du premier ensemble de paramètres associés, dans lequel la première fonction de relation de mappage est utilisée pour représenter une relation de mappage entre le paramètre d'état de fonctionnement dans le premier ensemble de paramètres associés et le premier paramètre de température.

9.  Appareil de commande (70) selon la revendication 8, dans lequel, dans la première fonction de relation de mappage, la valeur du premier paramètre de température est une différence entre une valeur maximale prédéfinie du premier paramètre de température et une première valeur de réglage, et la première valeur de réglage est obtenue en exécutant une addition pondérée sur des valeurs de tous les paramètres d'état de fonctionnement dans le premier ensemble de paramètres associés sur la base de valeurs de poids correspondant respectivement à tous les paramètres d'état de fonctionnement dans le premier ensemble de paramètres associés.

10. Appareil de commande (70) selon la revendication 9, dans lequel l'appareil de commande (70) comprend en outre :
une quatrième unité de détermination (706), configurée pour déterminer, sur la base d'une instruction d'utilisateur, des valeurs de poids correspondant respectivement à tous les paramètres d'état de fonctionnement dans le premier ensemble de paramètres associés.

11. Appareil de commande (70) selon l'une quelconque des revendications 7 à 10, dans lequel

la deuxième unité de détermination (703) est spécifiquement configurée pour déterminer, à partir de l'ensemble de paramètres d'état, un paramètre d'état de fonctionnement associé au second paramètre de température, pour obtenir un second ensemble de paramètres associés ; et
la deuxième unité de détermination (703) est en outre spécifiquement configurée pour déterminer la valeur du second paramètre de température sur la base d'une seconde fonction de relation de mappage prédéfinie et du second ensemble de paramètres associés, dans lequel la seconde fonction de relation de mappage est utilisée pour représenter une relation de mappage entre le paramètre d'état de fonctionnement dans le second ensemble de paramètres associés et le second paramètre de température.

12. Appareil de commande (70) selon la revendication 11, dans lequel, dans la seconde fonction de relation de mappage, la valeur du second paramètre de température est une différence entre une valeur maximale prédéfinie du second paramètre de température et une seconde valeur de réglage, la seconde valeur de réglage est associée avec un seuil de réglage prédéfini et un rapport entre une valeur d'un paramètre d'état de fonctionnement cible et une valeur nominale correspondant au paramètre d'état de fonctionnement cible, et le paramètre d'état de fonctionnement cible est un paramètre d'état de fonctionnement dans le second ensemble de paramètres associés.

13. Appareil de commande (80), comprenant un processeur (801), dans lequel le processeur (801) est couplé à une mémoire (802), la mémoire (802) est configurée pour stocker un programme informatique ou des instructions, et le processeur (801) est configuré pour exécuter le programme informatique ou les instructions dans la mémoire (802), pour permettre à l'appareil de commande (80) d'exécuter le procédé de commande selon l'une quelconque des revendications 1 à 6.

14. Support de stockage lisible par ordinateur stockant un programme informatique, dans lequel le procédé de commande selon l'une quelconque des revendications 1 à 6 est mis en œuvre lorsque le programme est exécuté.

EP 3 971 675 B1

FIG. 1

FIG. 2

21

```
┌─────────────────────────────────────┐
│  Obtain a status parameter set and   │── 301
│     a detected temperature of a      │
│            first device              │
└─────────────────────────────────────┘
                   │
                   ▼
┌─────────────────────────────────────┐
│ Determine a value of a first         │── 302
│ temperature parameter in a target    │
│ adjustment function based on the     │
│ status parameter set                 │
└─────────────────────────────────────┘
                   │
                   ▼
┌─────────────────────────────────────┐
│ Determine a value of a second        │── 303
│ temperature parameter in the target  │
│ adjustment function based on the     │
│ status parameter set                 │
└─────────────────────────────────────┘
                   │
                   ▼
┌─────────────────────────────────────┐
│ Determine heat dissipating           │── 304
│ efficiency of a heat dissipating     │
│ element based on the value of the    │
│ first temperature parameter, the     │
│ value of the second temperature      │
│ parameter, and the detected          │
│ temperature                          │
└─────────────────────────────────────┘
                   │
                   ▼
┌─────────────────────────────────────┐
│ Control running of the heat          │── 305
│ dissipating element based on the     │
│ heat dissipating efficiency of the   │
│ heat dissipating element             │
└─────────────────────────────────────┘
```

FIG. 3

Obtain a status parameter set and a detected temperature of an inverter — 401

Determine, from the status parameter set, a running status parameter associated with a first temperature parameter, to obtain a first associated parameter set — 402

Determine a value of the first temperature parameter based on a preset first mapping relationship function and the first associated parameter set — 403

Determine, from the status parameter set, a running status parameter associated with a second temperature parameter, to obtain a second associated parameter set — 404

Determine a value of the second temperature parameter based on a preset second mapping relationship function and the second associated parameter set — 405

Determine heat dissipating efficiency of a heat dissipating element based on the value of the first temperature parameter, the value of the second temperature parameter, and the NTC temperature — 406

Control running of the heat dissipating element based on the heat dissipating efficiency of the heat dissipating element — 407

FIG. 4

FIG. 5

FIG. 6A

(1) Schematic diagram of an implementation effect of a technical solution of this application

(2) Schematic diagram of an implementation effect of a table lookup solution

FIG. 6B

Control apparatus 70

701
Obtaining unit

702
First determining unit

703
Second determining unit

704
Third determining unit

706
Fourth determining unit

705
Control unit

FIG. 7

Control apparatus 80

801
Processor

802
Memory

803
User interface

FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102017205033 A1
- EP 3267774 A1
- US 8594856 B2